# EUROPEAN PATENT SPECIFICATION

(11) **EP 2 144 251 B1**
(45) Date of publication and mention of the grant of the patent: **31.08.2016**
(21) Application number: 09251748.1
(22) Date of filing: 07.07.2009
(51) Int. Cl.: G11C 16/20

(54) **Multilayered nonvolatile memory with adaptive control**
Mehrschichtiger nicht flüchtiger Speicher mit einstellbarer Steuerung
Mémoire volatile multicouche dotée d'un contrôle adaptatif

(30) Priority: 07.07.2008 KR 20080065678
(43) Date of publication of application: 13.01.2010
(73) Proprietor: Samsung Electronics Co., Ltd., Suwon-si, Gyeonggi-do, 443-742 (KR)
(72) Inventor: Kim, Doo Gon, Gyeonggi-do (KR); Park, Ki Tae, Gyeonggi-do (KR); Kang, Myoung Gon, Gyeonggi-do (KR)
(74) Representative: Mounteney, Simon James

(56) References cited:
- US-A1- 2003 031 056
- US-A1- 2003 062 612
- US-A1- 2005 280 072
- US-A1- 2006 015 691
- US-A1- 2008 048 237

## Description

### BACKGROUND OF THE INVENTION

The present disclosure generally relates to nonvolatile semiconductor memory devices. More particularly, the present disclosure relates to multilayered nonvolatile semiconductor memory devices having adaptive control schemes.

US 2006/0015691 describes memory device trims.

US 2003/0031056 describes a non-volitile memory having a control mini-array.

### SUMMARY OF THE INVENTION

The present disclosure provides multilayered nonvolatile semiconductor memory devices with adaptive control schemes. Exemplary embodiments are provided. According to an aspect of the present invention a multilayered memory device comprises features as recited in claim 1

According to an aspect of the present invention, a method of driving a multilayered memory device comprises features as recited in claim 18.

The present disclosure will be further understood from the following description of exemplary embodiments, which is to be read in connection with the accompanying drawings.

### BRIEF DESCRIPTION OF THE DRAWINGS

The present disclosure provides multilayered nonvolatile semiconductor memory devices with adaptive control schemes in accordance with the following exemplary figures, in which:
Figure 1 shows a schematic graphical diagram of a program (PGM) pulse for a multilayered nonvolatile semiconductor memory device in accordance with an exemplary embodiment of the present disclosure;
Figure 2 shows a schematic block diagram of a first embodiment multilayered nonvolatile semiconductor memory device in accordance with an exemplary embodiment of the present disclosure;
Figure 3 shows a schematic block diagram of the lookup matrix of Figure 2 in greater detail, in accordance with an exemplary embodiment of the present disclosure;
Figure 4 shows a schematic block diagram of a block group set implementation in accordance with an exemplary embodiment of the present disclosure;
Figure 5 shows a schematic block diagram of a lookup matrix with block groups in accordance with an exemplary embodiment of the present disclosure;
Figure 6 shows a schematic block diagram of a first block grouping example in accordance with an exemplary embodiment of the present disclosure;
Figure 7 shows a schematic block diagram of a second block grouping example in accordance with an exemplary embodiment of the present disclosure;
Figure 8 shows a schematic block diagram of a third block grouping example in accordance with an exemplary embodiment of the present disclosure;
Figure 9 shows a schematic block diagram of a fourth block grouping example in accordance with an exemplary embodiment of the present disclosure;
Figure 10 shows a schematic flow diagram of a control method for lookup matrix setup in accordance with an exemplary embodiment of the present disclosure;
Figure 11 shows a schematic flow diagram of a memory cell programming method in accordance with an exemplary embodiment of the present disclosure;
Figure 12 shows a schematic flow diagram of a memory cell erase method in accordance with an exemplary embodiment of the present disclosure;
Figure 13 shows a schematic flow diagram of a memory cell read method in accordance with an exemplary embodiment of the present disclosure;
Figure 14 shows a schematic graphical diagram of an incremental step pulse programming (ISPP) signal in accordance with an exemplary embodiment of the present disclosure;
Figure 15 shows a schematic block diagram of a second embodiment multilayered nonvolatile semiconductor memory device in accordance with an exemplary embodiment of the present disclosure;
Figure 16 shows a schematic block diagram of the lookup matrix of Figure 15 in greater detail, in accordance with an exemplary embodiment of the present disclosure;
Figure 17 shows a schematic graphical diagram of an incremental step pulse programming (ISPP) signal in accordance with an exemplary embodiment of the present disclosure; and
Figure 18 shows a schematic graphical diagram of the threshold voltage (Vth) distribution resulting from the incremental step pulse programming (ISPP) signal of Figure 17 in accordance with an exemplary embodiment of the present disclosure.

### DETAILED DESCRIPTION OF PREFERRED EMBODIMENTS

Systems controlled by computers or microprocessors typically use Electrically Erasable Programmable Read-Only Memory (EEPROM) devices, which preferably have high density, high performance, and occupy increasingly smaller areas. In order to obtain larger-capacity NAND flash memory devices, a method of stacking memory cell arrays is in development. Three dimensional (3D) memory arrays comprise two or more layers of memory material, each layer of memory material having an array of memory cells.

There is a tendency for the threshold voltage distribution profile of memory cells to grow wider as the structure of memory cell is made multi-layered. For example, the component threshold voltage distribution profiles may be different between the threshold voltage distribution profiles of memory cells in a first layer versus those in a second layer.

The present disclosure provides a method for driving a memory cell under an optimized operating condition implementing a control scheme, where the control scheme divides a memory cell array into a plurality of predetermined groups. An exemplary nonvolatile memory device to be driven and controlled may have at least two memory cells having characteristics varying with structural shape or position, a lookup matrix for storing the information about characteristics block group sets and transferring the data in accordance with an address signal, and a state machine for controlling an optimized operating condition for the respective memory cells based on the characteristic information of the respective block group set.

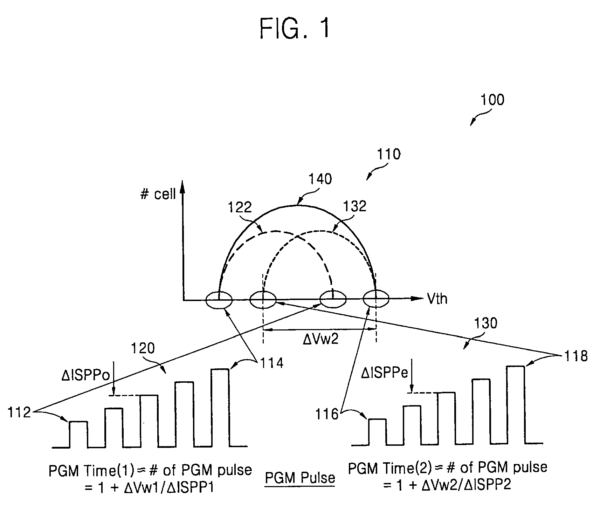

As shown in Figure 1, a program (PGM) pulse for a multi-layered nonvolatile semiconductor memory device is indicated generally by the reference numeral 100. The program pulse 100 has a cell number versus threshold voltage characteristic 110, which is plotted as a function of cell number (# cell) on the vertical axis versus threshold voltage (Vth) on the horizontal axis. The pulse 100 includes a first layer step-wise programming voltage (Vpgm) 120, and a second layer step-wise Vpgm 130. The first and second layer programming voltages are plotted as a function of voltage on the vertical axis versus time on the horizontal axis. The first layer Vpgm 120 has a start voltage level 112 and a stop voltage level 114, with a first inter-step increment of ΔISPPo. The second layer Vpgm 130 has a start voltage level 116 and a stop voltage level 118, with a second inter-step increment of ΔISPPe. Thus, the first layer Vpgm 120 has a first cell number versus Vth characteristic 122, and the second layer Vpgm 130 has a second cell number versus Vth characteristic 132. The sum of the first and second characteristics is a third cell number versus Vth characteristic 140.

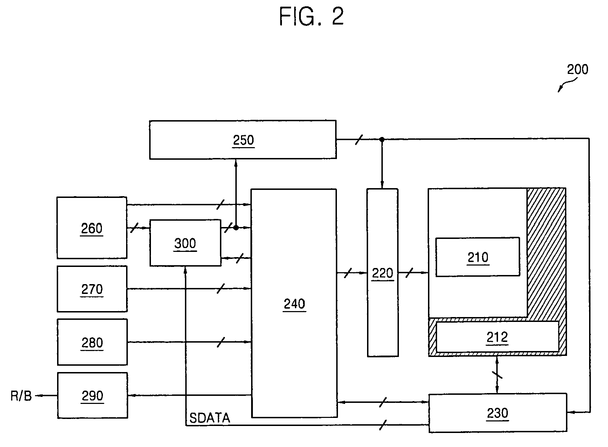

Turning to Figure 2, a first embodiment multilayered nonvolatile semiconductor memory device is indicated generally by the reference numeral 200. The memory device 200 includes a cell array 210 having a spare area 212, a row decoder 220 connected to the cell array, a page buffer 230 connected to the cell array, a periodic state machine 240 connected to the page buffer and the row decoder, an analog control machine 250 connected to the periodic state machine, page buffer and row decoder, address logic 260 connected to the periodic state machine, command logic 270 connected to the periodic state machine, a power detector 280 connected to the periodic state machine, a ready/busy (R/B) unit 290 connected to the periodic state machine for outputting a R/B signal, and a lookup matrix 300. Here, the lookup matrix 300 is connected to the address logic 260, the analog control machine 250, the periodic state machine 240 and the page buffer 230 for receiving specific signal data (SDATA) from the page buffer and providing lookup data to the analog control machine and the periodic state machine.

The SDATA may comprise structural information, such as line width, tested information, such as line capacitance or time to stabilize, and like information or characteristics for one or more specific memory cells. Preferably, the SDATA is different for a first layer and a second layer of memory cell arrays, and/or for odd and even numbered blocks of memory cells.

In operation of the first embodiment memory device 200, the spare area 212 contains non-volatile advanced information regarding respective block groups for program, read and erase operating conditions. When the memory device 200 powers up, the information is transferred from the spare area 212 to the lookup matrix 300. The state machine 240 controls optimized operating conditions for the respective memory blocks of the cell array 210 based on the data from the lookup matrix 300.

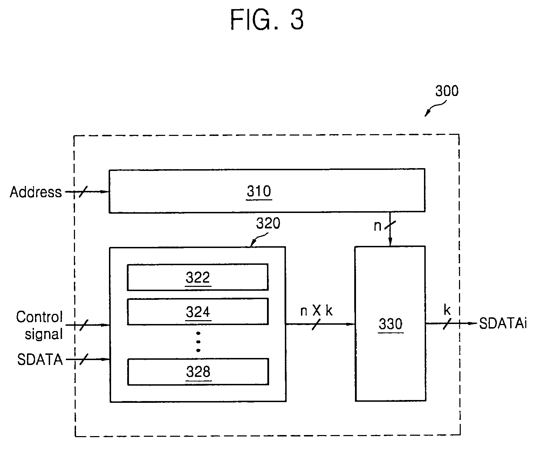

Turning now to Figure 3, the lookup matrix 300 of Figure 2 is shown in greater detail. The lookup matrix 300 includes an address comparator 310 for receiving an address signal from the address logic 260 of Figure 2, a lookup table 320 for receiving a control signal from the state machine 240 and SDATA from the page buffer 230, both of Figure 2, and an N-to-1 multiplexer (mux) 330 connected to the address comparator and the lookup table for receiving n-bit address and n-by-k bit lookup signals to output k-bit SDATAi to the analog control machine 250 and/or the periodic state machine 240, each of Figure 2. Here, the lookup table 320 includes a Block Group 0 set 322, a Block Group 1 set 324, up to a Block Group n set 328. Preferably, a register, latch, or the like may be used to store data from the block group n sets. SDATAi is defined as the signal of the respective Block Group set information for the respective memory block group upon optimized operating conditions. The lookup matrix 300 of the first embodiment may be implemented in volatile RAM.

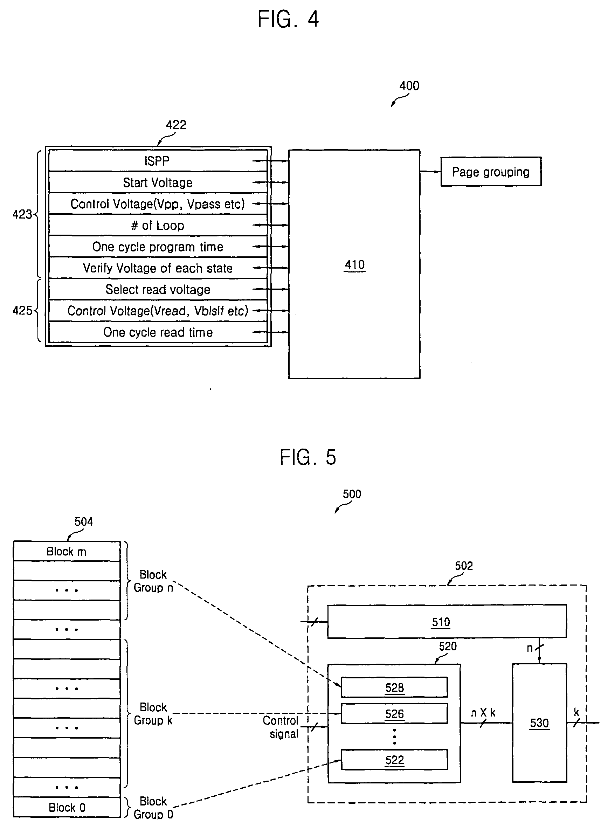

As shown in Figure 4, a Block Group set implementation is indicated generally by the reference numeral 400. The implementation includes a Block Group set 422 connected to a periodic state machine and/or page buffer 410, which outputs page grouping information. The Block Group set 422 includes program conditions 423 and read conditions 425. In alternate embodiments, the Block Group set may further include separate erase conditions.

The program conditions 422 may include incremental step pulse programming (ISPP), start voltage, control voltage (e.g., Vpp, Vpass), number of loops, single cycle program time, verify voltage for each state, and like information. The read conditions 425 may include select read voltage, control voltage (e.g., Vread, Vblslf), single cycle read time, and like information.

The Block Group sets and spare areas may store SDATA for memory cells of the cell array 240 of Figure 2, for example, upon the optimized operating conditions. The operating conditions include program/read/erase conditions such as a word line voltage, bit line voltage, well voltage, and time requirements thereof. If the information is only characteristic of program/read operating conditions, the control scheme may divide a memory cell array into a plurality of predetermined pages. If the information is characteristic of program/read/erase operating conditions, the control scheme may divide a memory cell array into a plurality of predetermined blocks.

Turning to Figure 5, a lookup matrix with block groups is indicated generally by the reference numeral 500. Here, the matrix with block groups includes a lookup matrix 502 disposed for receiving blocks 504 from a state machine. The blocks 504 are numbered from 0 through m, which are here divided into block groups 0, k and n.

The matrix 502 includes an address comparator 510 for receiving an address signal, a lookup table 520 for receiving a control signal and Block Group SDATA, and an N-to-1 multiplexer 530 connected to the address comparator and the lookup table for receiving n-bit address and n-by-k bit lookup signals to output k-bit data. Here, the lookup table 320 includes a Block Group 0 set 522, a Block Group k set 526, up to a Block Group n set 528.

In operation of this lookup table embodiment, SDATA is stored in the lookup table 520 by a periodic state machine. Here, the Block Group sets may be predetermined by a semiconductor manufacturer following the manufacture and testing of a representative and/or particular semiconductor chip. In alternate embodiments, the block group sets and/or the particular characteristics thereof may be determined adaptively by the memory device itself.

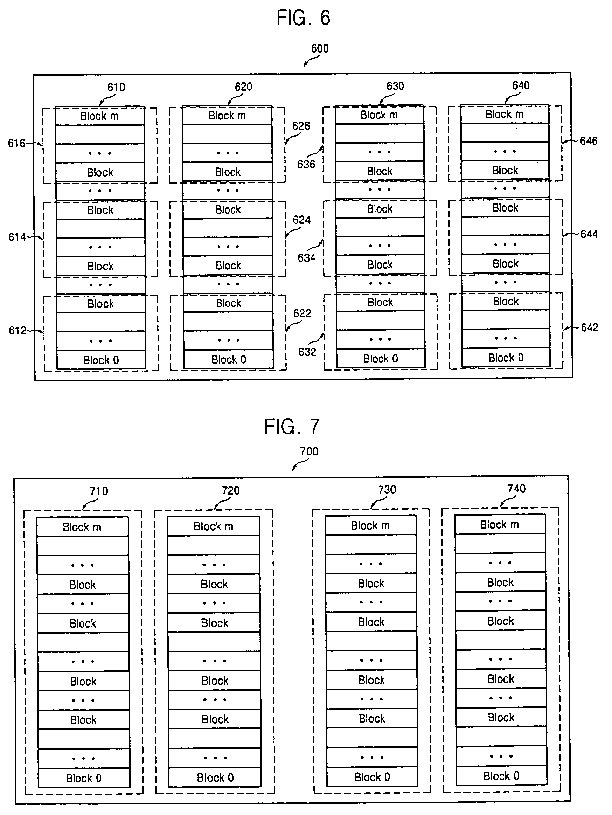

Turning now to Figure 6, a first block grouping example is indicated generally by the reference numeral 600. The block grouping 600 includes block groups 612, 614 and 616 in a first layer matrix 0, block groups 622, 624 and 626 in a second layer matrix 0, block groups 632, 634 and 636 in a first layer matrix 1, and block groups 642, 644 and 646 in a second layer matrix 1. Here, each span of 0 to m blocks is divided into three block groups.

As shown in Figure 7, a second block grouping example is indicated generally by the reference numeral 700. The block grouping 700 includes a block group 710 in a first layer matrix 0, a block group 720 in a second layer matrix 0, a block group 730 in a first layer matrix 1, and a block group 740 in a second layer matrix 1. Here, each span of 0 to m blocks is a single block group.

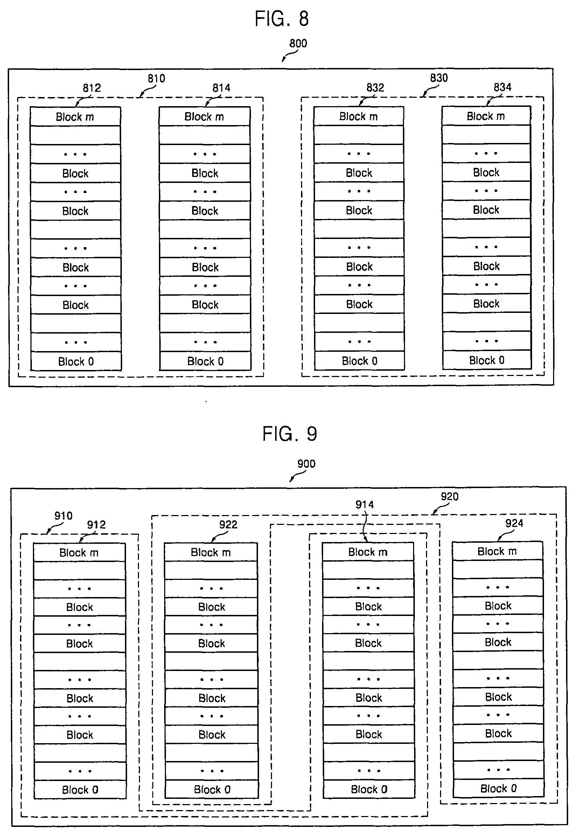

Turning to Figure 8, a third block grouping example is indicated generally by the reference numeral 800. The block grouping 800 includes a block group 810 including a first layer matrix 0, denoted 812, and a second layer matrix 0, denoted 814; and a block group 830 including a first layer matrix 1, denoted 832, and a second layer matrix 1, denoted 834. That is, each block group includes two spans of 0 to m blocks for the same matrix in a single block group.

Turning now to Figure 9, a fourth block grouping example is indicated generally by the reference numeral 900. The block grouping 900 includes a block group 910 including a first layer matrix 0, denoted 912, and a first layer matrix 1, denoted 914; and a block group 920 including a second layer matrix 0, denoted 922, and a second layer matrix 1, denoted 924. That is, each block group includes two spans of 0 to m blocks for the same layer in a single block group.

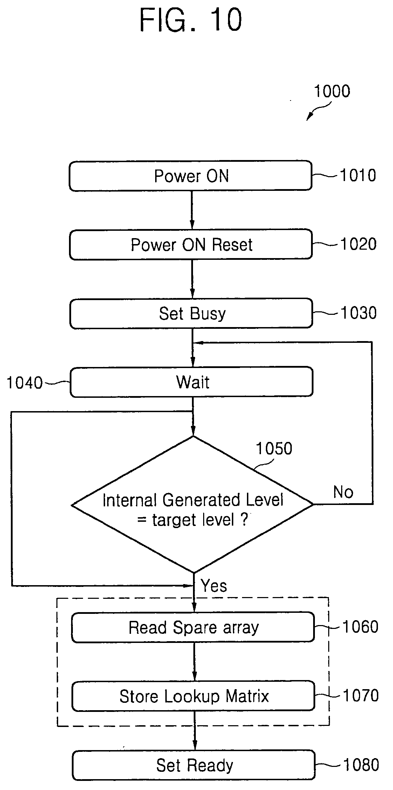

As shown in Figure 10, a control method for lookup matrix setup is indicated generally by the reference numeral 1000. Here, a function block 1010 to perform a power on sequence passes control to a function block 1020 to perform a power on reset, which passes control to a function block 1030 to set the busy status, which, in turn, passes control to a wait block 1040. The wait block 1040 passes control to a decision block 1050, which determines whether the internally generated voltage level is equal to the target level. If not, the decision block passes control back to the wait block 1040. But, if so, the decision block passes control to a function block 1060 to read data from the spare array. The block 1050 may stabilize Vcc, for example. The function block 1060, in turn, passes control to a function block 1070 to store the read data in the lookup matrix. The function block 1070 passes control to a function block 1080, which sets the ready status.

In operation, when power is turned on, a memory device performs a power on reset sequence, and a busy signal of the memory device moves it to a 'Set Busy' state. After a 'Wait' state, it determines whether Internal Generated Level has reached the target level. If the Generated level has reached the target level, SDATA is transferred from the spare area and stored in the lookup matrix. Afterwards, the busy signal is deactivated and the device moves to the ready state.

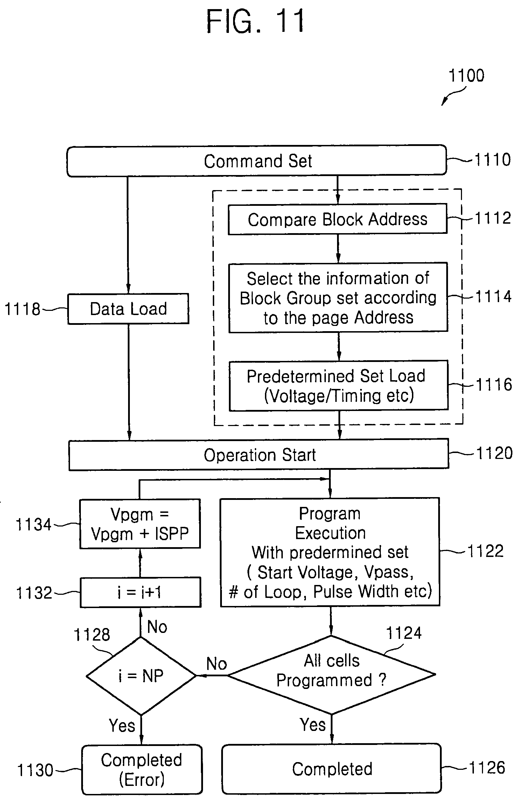

Turning to Figure 11, a memory cell programming method is indicated generally by the reference numeral 1100. A function block 1110 performs a command set and passes control to parallel function blocks 1112 and 1118. The function block 1112 compares the block address and passes control to a function block 1114. The function block 1114 selects the information for the respective Block Group set according to the page address, for example, and passes control to a function block 1116. The function block 1116, in turn, implements the predetermined set load, such as voltage, timing, and the like, and passes control to a function block 1120. Meanwhile, the parallel function block 1118 performs a data load and passes control to the function block 1120. When both function blocks 1116 and 1118 have passed control to function block 1120, the function block 1120 becomes enabled and executes an operation start.

Next, the function block 1120 passes control to a function block 1122, which performs program execution with the predetermined set including start voltage, Vpass, number of loops, pulse width and the like. The function block 1122 passes control to a decision block 1124, which determines whether all cells have been programmed. If so, the decision block 1124 passes control to a function block 1126, which indicates a successful completion. If not, the decision block 1124 passes control to another decision block 1128, which determines whether the loop counter i has reached the value NP, which indicates the maximum number of loops. If so, the decision block 1128 passes control to a function block 1130, which indicates a completion with error. If not, the decision block 1128 passes control to a function block 1132, which increments the loop counter i by one and passes control to a function block 1134. The function block 1134, in turn, increments Vpgm by ISPP, and passes control to the function block 1122.

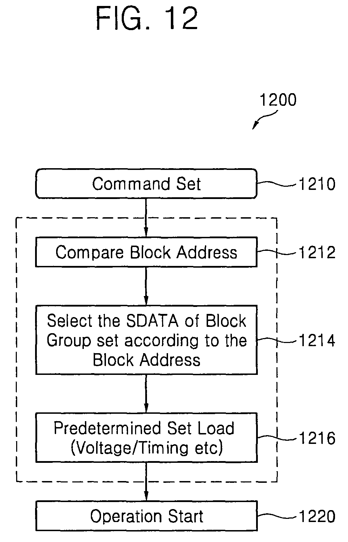

Turning now to Figure 12, a memory cell erase method is indicated generally by the reference numeral 1200. The memory cell erase method 1200 is similar to the memory cell programming method 1100 of Figure 11, so duplicate graphics and description may be omitted. The memory cell erase method 1200 includes a function block 1210, which performs a command set and passes control to a function block 1212. The function block 1112 compares the block address and passes control to a function block 1214. The function block 1214 selects the *SDATA* for the respective Block Group set according to the *block* address, for example, and passes control to a function block 1216. The function block 1216, in turn, implements the predetermined set load, such as voltage, timing, and the like, and passes control to a function block 1220.

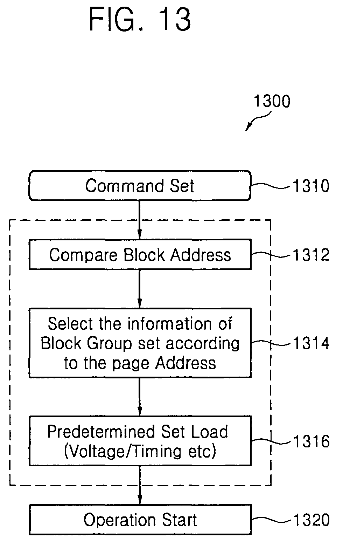

As shown in Figure 13, a memory cell read method is indicated generally by the reference numeral 1300. The memory cell read method 1200 is similar to the memory cell programming and erase methods 1100 and 1200 of Figures 11 and 12, respectively, so duplicate graphics and description may be omitted. In the memory cell read method 1300, a function block 1310 performs a command set and passes control to a function block 1312. The function block 1312 compares the block address and passes control to a function block 1314. The function block 1314 selects the *information* for the respective Block Group set according to the *page* address, for example, and passes control to a function block 1316. The function block 1316, in turn, implements the predetermined set load, such as voltage, timing, and the like, and passes control to a function block 1320.

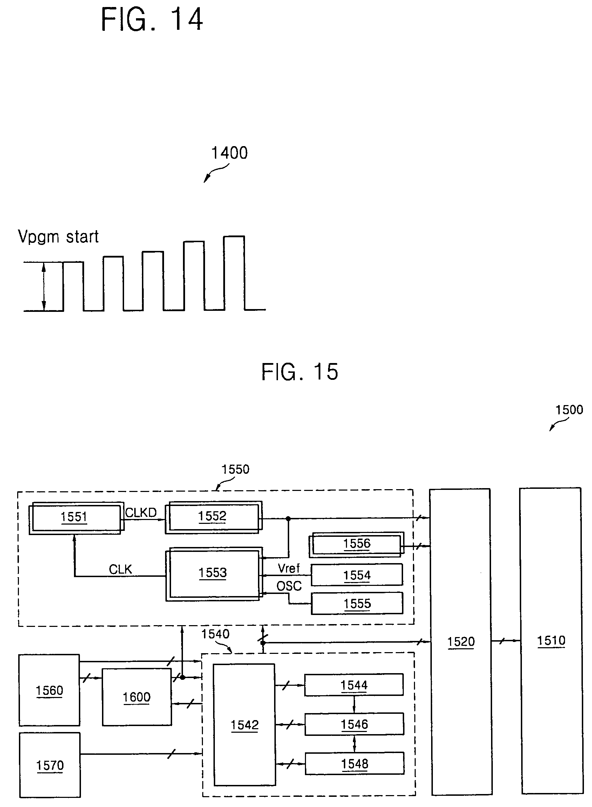

Turning to Figure 14, an incremental step pulse programming (ISPP) signal is indicated generally by the reference numeral 1400. The ISPP signal is plotted as a function of voltage on the vertical axis versus time on the horizontal axis. The ISPP signal is a pulsed signal that varies between ground and an increasing maximum voltage. The maximum voltage for the first pulse is the voltage potential Vpgm_start, and each subsequent pulse is increased by a delta_ISPP voltage step until the maximum number of loops (NP) has been reached.

Turning now to Figure 15, a second embodiment multilayered nonvolatile semiconductor memory device is indicated generally by the reference numeral 1500. The memory device 1500 includes a cell array 1510, which need not have a spare area, a core control/device block 1520 connected to the cell array, a periodic state machine 1540 connected to the core control/device block, an analog control machine 1550 connected to the periodic state machine and the core control/device block, address logic 1560 connected to the periodic state machine, command logic 1570 connected to the periodic state machine, and a lookup matrix 1600. Here, the lookup matrix 1600 is connected to the address logic 1560, the analog control machine 1550, and the periodic state machine 1540 for providing lookup data to the analog control machine and the periodic state machine.

The periodic state machine 1540 includes core control logic 1542 connected to a timer control 1544. The timer control is connected to a scheduler 1546. The scheduler, in turn, is connected to both the core control logic and a loop counter 1548, which is also connected to the core control logic.

The analog control machine 1550 includes a clock driver 1551 connected to a charge pump 1552 for providing a CLKD signal to the charge pump. The charge pump provides increased voltage to a voltage regulator 1553, and an output to the core control/driver block 1520. The voltage regulator is connected between the charge pump and the clock driver for providing a CLK signal to the clock driver. A voltage reference 1554 provides a Vref signal to the voltage regulator, and an oscillator provides an OSC signal to the voltage regulator. An indirect vector control (IVC) unit 1556 provides another output to the core control/driver block 1520.

The lookup data may include SDATA with structural information, such as line width, tested information, such as line capacitance or time to stabilize, and like information or characteristics for one or more specific memory cells. Preferably, the SDATA is different for a first layer and a second layer of memory cell arrays, and/or for odd and even numbered blocks of memory cells.

In operation of the second embodiment memory device 1500, the lookup matrix is itself implemented in non-volatile or flash memory, so it does not require start-up information from a spare area. This is in contrast to the embodiment 200 of Figure 2. The state machine 1540 controls optimized operating conditions for the respective memory blocks of the cell array 1510 based on the data from the lookup matrix 1600.

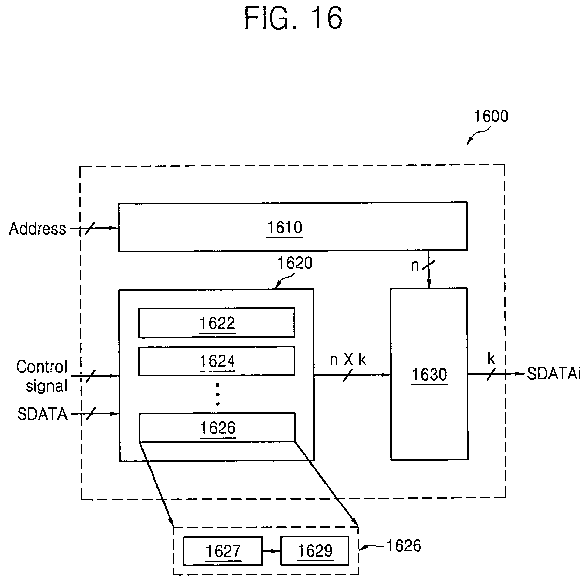

As shown in Figure 16, the lookup matrix 1600 of Figure 15 is shown in greater detail. The lookup matrix 1600 includes an address comparator 1610 for receiving an address signal from the address logic 1560 of Figure 15, a lookup table 1620 for receiving a control signal from the state machine 1540 of Figure 2, and an N-to-1 multiplexer (mux) 1630 connected to the address comparator and the lookup table for receiving n-bit address and n-by-k bit lookup signals to output k-bit SDATAi to the analog control machine 1550 and/or the periodic state machine 1540, each of Figure 2.

The lookup table 1620 includes a Block Group 0 set 1622, a Block Group 1 set 1624, and up to a Block Group n set 1626. Preferably, a non-volatile type device may be used to store data from the block group sets. Here, each block group set 1622-1626 is stored in non-volatile memory, and includes a storing array 1627 connected to a latch 1629. SDATAi is defined as the signal of the respective Block Group set information for the respective memory block group upon optimized operating conditions.

In operation, the lookup matrix receives an address from the address logic and sends the corresponding Block Group set information to at least one of the analog control machine or the periodic state machine. Since the information is originally stored in the lookup matrix, there is no need for a spare area.

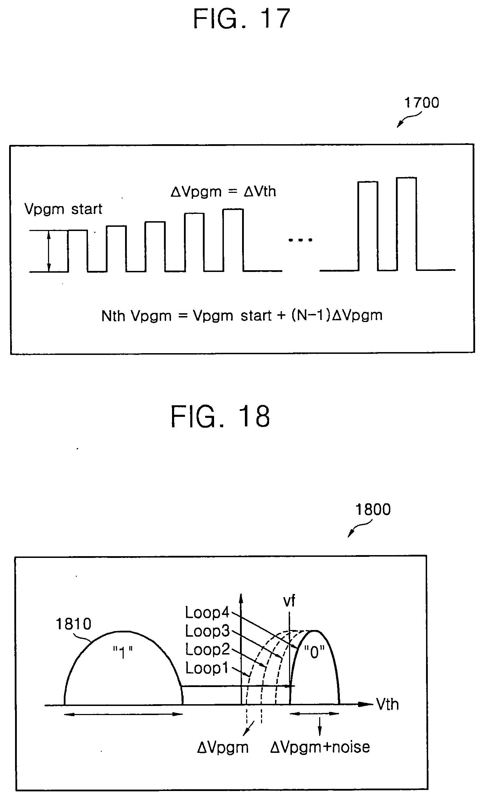

Turning to Figure 17, an incremental step pulse programming (ISPP) signal is indicated generally by the reference numeral 1700. The ISPP signal is plotted as a function of voltage on the vertical axis versus time on the horizontal axis. The ISPP signal is a pulsed signal that varies between a minimum and an increasing maximum voltage. The maximum voltage for the first loop is the voltage potential Vpgm_start, and each subsequent loop's pulse is increased by a delta_Vpgm voltage step until the maximum number of loops (NP) has been reached. Here, the delta_Vpgm voltage step is equal to a delta_Vth threshold voltage step. The Nth loop Vpgm voltage is equal to Vpgm_start plus (N-1) times delta_Vpgm.

Turning now to Figure 18, the threshold voltage (Vth) distribution resulting from the incremental step pulse programming (ISPP) signal 1700 of Figure 17 is indicated generally by the reference numeral 1800. Here, "1" valued memory cells have a Vth distribution 1810. On the other hand, "0" valued memory cells have a Vth distribution Loop1 after the first loop, Loop2 after the second loop, Loop3 after the third loop, and Loop4 after the last or Nth loop. Each successive loop has a minimum voltage level that exceeds the previous loop's minimum voltage level by delta_Vpgm. After the Nth loop, the voltage distribution of all "0" valued memory cells meets or exceeds a minimum fine voltage (Vf). The width of the final voltage distribution is equal to delta_Vpgm plus a noise factor.

In operation, the threshold voltage (Vth) distribution of the NAND flash memory device is accurately controlled by using the Increment Step Pulse Programming (ISPP) method to control the Vth of the memory cells. In the ISPP method, the program voltage is increased in stages by a determined increment by repeating program loops of a program cycle. As a programming operation is progressing, the threshold voltage of the programmed cells is increased by an increment determined in each program loop.

Thus, an exemplary embodiment method of driving a nonvolatile memory device includes determining a structural shape and position of a memory cell to be driven, and driving the memory cell under an optimized operating condition based on that determination. Alternate embodiments are contemplated. For example, such alternate methods may be adapted to drive nonvolatile memory devices having memory arrays in at least a first layer and a second layer, where the memory arrays are arranged into matrices or block group sets extent in the first layer, the second layer, and/or portions of both. The operating conditions may include program, read and/or erase operating conditions, where the operating conditions of the layers, matrices and/or block group sets are different from each other.

In other embodiments, larger blocks or smaller pages may be used for groupings depending on the operation to be performed. For example, the program and read operations preferably use a page grouping for NAND type flash memory devices. On the other hand, the erase operation preferably uses a block grouping for NAND type flash memory devices. Here, the page size or depth may be 8K bytes, for example.

Another alternate embodiment includes multi-level cells (MLC), where the one shot distribution is very wide. To make the MLC distribution wider, it is desirable to make the program distribution tighter by adapting the program methods provided herein.

## Claims

1. A multilayered memory device (200; 1500) comprising:
a plurality of memory cells (210; 1510) organized into a plurality of groups (600; 700; 800; 900) the plurality of memory cells including at least two layers of memory cells, wherein each group comprises memory cells in different layers;
and
a control circuit having a look-up matrix (300; 500; 1600) for providing control parameters for each of the plurality of groups,
wherein characteristics of each group are stored in the look-up matrix, and the control parameters for each group are responsive to the stored characteristics for that group, and the stored characteristics and the provided control parameters are different for each group

2. The device of Claim 1, each of the plurality of groups having characteristics differing with location of the group within the structure of the device.

3. The device of Claim 1, each of the plurality of groups having characteristics differing in accordance with electronic test results for the device.

4. The device (200) of Claim 1, further comprising a memory array having a spare area (212),
wherein the characteristics are retrieved from the spare area and stored in the look-up matrix.

5. The device of Claim 1, further comprising a memory array,
wherein the look-up table is nonvolatile memory separate from the memory array and the characteristics are provided by the look-up table.

6. The device of Claim 1, the characteristics for each group comprising at least one of program conditions, read conditions, or erase conditions.

7. The device of Claim 6, the program conditions comprising at least one of an incremental step pulse programming voltage, a start voltage, a program control voltage, a maximum number of loops, a one-cycle program time, or a verification voltage for each state.

8. The device of Claim 6, the read conditions comprising at least one of a select read voltage, a read control voltage, or a one-cycle read time.

9. The device of Claim 6, the erase conditions comprising at least one of an erase voltage or an erase time.

10. The device of Claim 1 wherein a range of at least one control parameter for each group is different from a range of the at least one control parameter for each other group.

11. The device of Claim 1 wherein the memory cells are NAND flash memory cells.

12. The device of Claim 11, the control parameters comprising at least one loop program voltage applied to a page of NAND flash memory.

13. The device of Claim 11, the control parameters comprising at least one loop read voltage applied to a page of NAND flash memory.

14. The device of Claim 11, the control parameters comprising at least one erase voltage applied to a block of NAND flash memory.

15. The device of Claim 1 wherein the memory cells are nonvolatile.

16. The device of Claim 1, the look-up matrix (1600) further comprising non-volatile storage for storing the group characteristics without a spare area.

17. The device of Claim 1 wherein each of the plurality of memory cells has the same number of logic levels.

18. A method of driving a multilayered memory device (200; 1500), the method comprising:
organizing a plurality of memory cells (210; 1510) into a plurality of groups (600; 700; 800; 900), wherein each group comprises memory cells in different layers;
storing characteristics for each group in a look-up matrix (300; 500; 1600); providing control parameters for a group responsive to its stored characteristics;
and
driving each memory cell in accordance with its provided control parameters;
comparing the page address of a memory cell to be accessed with the block address for a group;
selecting the characteristics for the group that includes the page address; and using the control parameters, including at least a voltage level and a timing period, that correspond to the selected group characteristics,
wherein the plurality of memory cells include at least three layers of memory cells, and the stored characteristics and provided control parameters are different for each group.

19. The method of Claim 18, each of the plurality of groups having characteristics differing with location of the group within the structure of the device.

20. The method of Claim 18, further comprising:
electronically testing a representative sample of the device; and
assigning characteristics for each of the plurality of groups in accordance with results of the electronic testing.

21. The method of Claim 18, further comprising:
retrieving the characteristics from a spare area (211) of the memory device; and
storing the characteristics in the look-up matrix.

22. The method of Claim 18, further comprising storing the group characteristics in the look-up matrix,
wherein the look-up matrix has nonvolatile memory.

23. The method of Claim 18 wherein the characteristics for each group include at least one of program conditions, read conditions, or erase conditions.

24. The method of Claim 23 wherein the program conditions include at least one of an incremental step pulse programming voltage, a start voltage, a program control voltage, a maximum number of loops, a one-cycle program time, or a verification voltage for each state.

25. The method of Claim 23 wherein the read conditions include at least one of a select read voltage, a read control voltage, or a one-cycle read time.

26. The method of Claim 23 wherein the erase conditions include at least one of an erase voltage or an erase time.

27. The method of Claim 18 wherein a range of at least one control parameter for each group is different from a range of the at least one control parameter for each other group.

28. The method of Claim 18 wherein the memory cells are NAND flash memory cells.

29. The method of Claim 28 wherein the control parameters include at least one loop program voltage applied to a page of NAND flash memory.

30. The method of Claim 28 wherein the control parameters include at least one loop read voltage applied to a page of NAND flash memory.

31. The method of Claim 28 wherein the control parameters include at least one erase voltage applied to a block of NAND flash memory.

32. The method of Claim 18 wherein the memory cells are nonvolatile.

33. The method of Claim 18 wherein each of the plurality of memory cells has the same number of logic levels.

## Patentansprüche

1. Mehrschichtige Speichervorrichtung (200; 1500), umfassend:
eine Vielzahl von Speicherzellen (210; 1510), die zu einer Vielzahl von Gruppen (600; 700; 800; 900) organisiert sind, wobei die Vielzahl von Speicherzellen mindestens zwei Schichten von Speicherzellen einschließt, worin jede Gruppe Speicherzellen in unterschiedlichen Schichten umfasst;
und
eine Steuerungsschaltung mit einer Nachschlagematrix (300; 500; 1600) zum Bereitstellen von Steuerparametern für jede aus der Vielzahl von Gruppen,
worin charakteristische Merkmale jeder Gruppe in der Nachschlagematrix gespeichert werden und die Steuerparameter für jede Gruppe auf die gespeicherten charakteristischen Merkmale für diese Gruppe ansprechen und die gespeicherten charakteristischen Merkmale und die bereitgestellten Steuerparameter für jede Gruppe verschieden sind.

2. Vorrichtung nach Anspruch 1, wobei jede aus der Vielzahl von Gruppen charakteristische Merkmale hat, die sich mit dem Ort der Gruppe innerhalb der Struktur der Vorrichtung unterscheiden.

3. Vorrichtung nach Anspruch 1, wobei jede aus der Vielzahl von Gruppen charakteristische Merkmale hat, die sich gemäß elektronischen Testergebnissen für die Vorrichtung unterscheiden.

4. Vorrichtung (200) nach Anspruch 1, ferner eine Speicheranordnung mit einem Reservebereich (212) umfassend,
worin die charakteristischen Merkmale aus dem Reservebereich abgerufen und in der Nachschlagematrix gespeichert werden.

5. Vorrichtung nach Anspruch 1, ferner eine Speicheranordnung umfassend,
worin die Nachschlagetabelle ein von der Speicheranordnung getrennter nichtflüchtiger Speicher ist und die charakteristischen Merkmale durch die Nachschlagetabelle bereitgestellt werden.

6. Vorrichtung nach Anspruch 1, wobei die charakteristischen Merkmale für jede Gruppe mindestens eines von Folgendem umfassen: Programmierbedingungen, Lesebedingungen oder Löschbedingungen.

7. Vorrichtung nach Anspruch 6, wobei die Programmierbedingungen mindestens eines von Folgendem umfassen: eine Inkrementalschritt-Impulsprogrammierspannung, eine Anfangsspannung, eine Programmiersteuerspannung, eine maximale Schleifenzahl, eine Programmierzeit für einen Zyklus oder eine Nachprüfspannung für jeden Zustand.

8. Vorrichtung nach Anspruch 6, wobei die Lesebedingungen mindestens eines von Folgendem umfassen: eine Auswahllesespannung, eine Lesesteuerspannung oder eine Lesezeit für einen Zyklus.

9. Vorrichtung nach Anspruch 6, wobei die Löschbedingungen mindestens eines von Folgendem umfassen: eine Löschspannung oder eine Löschzeit.

10. Vorrichtung nach Anspruch 1, worin sich ein Wertebereich mindestens eines Steuerparameters für jede Gruppe von einem Wertebereich des mindestens einen Steuerparameters für jede andere Gruppe unterscheidet.

11. Vorrichtung nach Anspruch 1, worin die Speicherzellen NAND-Flash-Speicherzellen sind.

12. Vorrichtung nach Anspruch 11, wobei die Steuerparameter mindestens eine an eine Seite des NAND-Flash-Speichers angelegte Schleifenprogrammierspannung umfassen.

13. Vorrichtung nach Anspruch 11, wobei die Steuerparameter mindestens eine an eine Seite des NAND-Flash-Speichers angelegte Schleifen-Lesespannung umfassen.

14. Vorrichtung nach Anspruch 11, wobei die Steuerparameter mindestens eine an einen Block eines NAND-Flash-Speichers angelegte Löschspannung umfassen.

15. Vorrichtung nach Anspruch 1, worin die Speicherzellen nichtflüchtig sind.

16. Vorrichtung nach Anspruch 1, wobei die Nachschlagematrix (1600) ferner nichtflüchtigen Speicher zum Speichern der charakteristischen Gruppenmerkmale ohne einen Reservebereich umfasst.

17. Vorrichtung nach Anspruch 1, worin jede aus der Vielzahl von Speicherzellen die gleiche Anzahl von Logikpegeln hat.

18. Verfahren zum Ansteuern einer mehrschichtigen Speichervorrichtung (200; 1500), wobei das Verfahren umfasst:
Organisieren einer Vielzahl von Speicherzellen (210; 1510) zu einer Vielzahl von Gruppen (600; 700; 800; 900), worin jede Gruppe Speicherzellen in unterschiedlichen Schichten umfasst;
Speichern von charakteristischen Merkmalen für jede Gruppe in einer Nachschlagematrix (300; 500; 1600);
Bereitstellen von Steuerparametern für eine Gruppe als Antwort auf ihre gespeicherten charakteristischen Merkmale; und
Ansteuern jeder Speicherzelle gemäß ihren bereitgestellten Steuerparametern;
Vergleichen der Seitenadresse einer Speicherzelle, auf die zugegriffen werden soll, mit der Blockadresse für eine Gruppe;
Auswählen der charakteristischen Merkmale für diejenige Gruppe, welche die Seitenadresse einschließt; und
Verwenden der Steuerparameter einschließlich mindestens eines Spannungspegels und einer Taktperiode, die den ausgewählten charakteristischen Gruppenmerkmalen entsprechen,
worin die Vielzahl von Speicherzellen mindestens drei Schichten von Speicherzellen einschließt und die gespeicherten charakteristischen Merkmale und bereitgestellten Steuerparameter für jede Gruppe unterschiedlich sind.

19. Verfahren nach Anspruch 18, wobei jede aus der Vielzahl von Gruppen charakteristische Merkmale hat, die sich mit dem Ort der Gruppe innerhalb der Struktur der Vorrichtung unterscheiden.

20. Verfahren nach Anspruch 18, ferner umfassend:
elektronisches Testen einer repräsentativen Stichprobe der Vorrichtung; und
Zuweisen von charakteristischen Merkmalen für jede aus der Vielzahl von Gruppen gemäß Ergebnissen des elektronischen Testens.

21. Verfahren nach Anspruch 18, ferner umfassend:
Abrufen der charakteristischen Merkmale aus einem Reservebereich (211) der Speichervorrichtung; und
Speichern der charakteristischen Merkmale in der Nachschlagematrix.

22. Verfahren nach Anspruch 18, ferner umfassend: Speichern der charakteristischen Gruppenmerkmale in der Nachschlagematrix,
worin die Nachschlagematrix nichtflüchtigen Speicher hat.

23. Verfahren nach Anspruch 18, worin die charakteristischen Merkmale für jede Gruppe mindestens eines von Folgendem umfassen: Programmierbedingungen, Lesebedingungen oder Löschbedingungen.

24. Verfahren nach Anspruch 23, wobei die Programmierbedingungen mindestens eines von Folgendem umfassen: eine Inkrementalschritt-Impulsprogrammierspannung, eine Anfangsspannung, eine Programmiersteuerspannung, eine maximale Schleifenzahl, eine Programmierzeit für einen Zyklus oder eine Nachprüfspannung für jeden Zustand.

25. Verfahren nach Anspruch 23, wobei die Lesebedingungen mindestens eines von Folgendem umfassen: eine Auswahllesespannung, eine Lesesteuerspannung oder eine Lesezeit für einen Zyklus.

26. Verfahren nach Anspruch 23, wobei die Löschbedingungen mindestens eines von Folgendem umfassen: eine Löschspannung oder eine Löschzeit.

27. Verfahren nach Anspruch 18, worin sich ein Wertebereich mindestens eines Steuerparameters für jede Gruppe von einem Wertebereich des mindestens einen Steuerparameters für jede andere Gruppe unterscheidet.

28. Verfahren nach Anspruch 18, worin die Speicherzellen NAND-Flash-Speicherzellen sind.

29. Verfahren nach Anspruch 28, worin die Steuerparameter mindestens eine an eine Seite des NAND-Flash-Speichers angelegte Schleifenprogrammierspannung umfassen.

30. Verfahren nach Anspruch 28, worin die Steuerparameter mindestens eine an eine Seite des NAND-Flash-Speichers angelegte Schleifen-Lesespannung umfassen.

31. Verfahren nach Anspruch 28, worin die Steuerparameter mindestens eine an einen Block des NAND-Flash-Speichers angelegte Löschspannung umfassen.

32. Verfahren nach Anspruch 18, worin die Speicherzellen nichtflüchtig sind.

33. Verfahren nach Anspruch 18, worin jede aus der Vielzahl von Speicherzellen die gleiche Anzahl von Logikpegeln hat.

## Revendications

1. Dispositif de mémoire multicouche (200 ; 1500) comprenant :
une pluralité de cellules de mémoire (210 ; 1510) organisées en une pluralité de groupes (600 ; 700 ; 800 ; 900), la pluralité de cellules de mémoire incluant au moins deux couches de cellules de mémoire, dans lequel chaque groupe comprend des cellules de mémoire dans différentes couches ;
et
un circuit de commande présentant une matrice de consultation (300 ; 500 ; 1600) pour fournir des paramètres de commande pour chaque groupe de la pluralité de groupes ;
dans lequel des caractéristiques de chaque groupe sont stockées dans la matrice de consultation et les paramètres de commande pour chaque groupe répondent aux caractéristiques stockées pour ce groupe, et les caractéristiques stockées et les paramètres de commande fournis sont différents pour chaque groupe.

2. Dispositif selon la revendication 1, dans lequel chaque groupe de la pluralité de groupes présente des caractéristiques qui diffèrent selon l'emplacement du groupe au sein de la structure du dispositif.

3. Dispositif selon la revendication 1, dans lequel chaque groupe de la pluralité de groupes présente des caractéristiques qui diffèrent selon des résultats de test électronique pour le dispositif.

4. Dispositif (200) selon la revendication 1, comprenant en outre une matrice mémoire présentant une zone de réserve (212),
dans lequel les caractéristiques sont extraites de la zone de réserve et stockées dans la matrice de consultation.

5. Dispositif selon la revendication 1, comprenant en outre une matrice mémoire ;
dans lequel la table de consultation est une mémoire non volatile distincte de la matrice mémoire et les caractéristiques sont fournies par la table de consultation.

6. Dispositif selon la revendication 1, dans lequel les caractéristiques pour chaque groupe comportent au moins l'une parmi des conditions de programme, des conditions de lecture ou des conditions d'effacement.

7. Dispositif selon la revendication 6, dans lequel les conditions de programme comportent au moins l'un des éléments parmi une tension de programmation d'impulsions par étapes incrémentales, une tension de début, une tension de commande de programme, un nombre maximum de boucles, un temps de programme monocycle ou une tension de vérification pour chaque état.

8. Dispositif selon la revendication 6, dans lequel les conditions de lecture comportent au moins l'un des éléments parmi une tension de sélection de lecture, une tension de lecture de commande ou un temps de lecture monocycle.

9. Dispositif selon la revendication 6, dans lequel les conditions d'effacement comportent au moins l'un des éléments parmi une tension d'effacement ou un temps d'effacement.

10. Dispositif selon la revendication 1, dans lequel une plage d'au moins un paramètre de commande pour chaque groupe est différente d'une plage d'au moins un paramètre de commande pour chaque autre groupe.

11. Dispositif selon la revendication 1, dans lequel les cellules de mémoire sont des cellules de mémoire flash NON-ET.

12. Dispositif selon la revendication 11, dans lequel les paramètres de commande comportent au moins une tension de programme en boucle appliquée à une page de mémoire flash NON-ET.

13. Dispositif selon la revendication 11, dans lequel les paramètres de commande comportent au moins une tension de lecture en boucle appliquée à une page de mémoire flash NON-ET.

14. Dispositif selon la revendication 11, dans lequel les paramètres de commande comportent au moins une tension d'effacement appliquée à un bloc de mémoire flash NON-ET.

15. Dispositif selon la revendication 1, dans lequel les cellules de mémoire sont non volatiles.

16. Dispositif selon la revendication 1, dans lequel la matrice de consultation (1600) comporte en outre un stockage non volatile pour stocker les caractéristiques de groupes sans zone de réserve.

17. Dispositif selon la revendication 1, dans lequel chaque cellule de la pluralité de cellules de mémoire présente le même nombre de niveaux logiques.

18. Procédé de commande d'un dispositif de mémoire multicouche (200 ; 1500), le procédé comprenant les étapes ci-dessous consistant à :
organiser une pluralité de cellules de mémoire (210 ; 1510) en une pluralité de groupes (600 ; 700 ; 800 ; 900), dans lequel chaque groupe comprend des cellules de mémoire dans différentes couches ;
stocker des caractéristiques pour chaque groupe dans une matrice de consultation (300 ; 500 ; 1600) ;
fournir des paramètres de commande pour un groupe en réponse à ses caractéristiques stockées ; et
commander chaque cellule de mémoire selon ses paramètres de commande fournis ;
comparer l'adresse de page d'une cellule de mémoire, à laquelle il convient d'accéder, à l'adresse de bloc pour un groupe ;
sélectionner les caractéristiques pour le groupe qui inclut l'adresse de page ; et
utiliser les paramètres de commande, y compris au moins un niveau de tension et une période de temporisation, qui correspondent aux caractéristiques de groupes sélectionnées ;
dans lequel la pluralité de cellules de mémoire inclut au moins trois couches de cellules de mémoire, et les caractéristiques stockées et les paramètres de commande fournis sont différents pour chaque groupe.

19. Procédé selon la revendication 18, dans lequel chaque groupe de la pluralité de groupes présente des caractéristiques qui diffèrent selon l'emplacement du groupe au sein de la structure du dispositif.

20. Procédé selon la revendication 18, comprenant en outre les étapes ci-dessous consistant à :
tester électroniquement un échantillon représentatif du dispositif ; et
affecter des caractéristiques pour chaque groupe de la pluralité de groupes selon les résultats du test électronique.

21. Procédé selon la revendication 18, comprenant en outre les étapes ci-dessous consistant à :
extraire les caractéristiques d'une zone de réserve (211) du dispositif de mémoire ; et
stocker les caractéristiques dans la matrice de consultation.

22. Procédé selon la revendication 18, comprenant en outre l'étape consistant à stocker les caractéristiques de groupes dans la matrice de consultation ;
dans lequel la matrice de consultation présente une mémoire non volatile.

23. Procédé selon la revendication 18, dans lequel les caractéristiques pour chaque groupe incluent au moins l'une parmi des conditions de programme, des conditions de lecture ou des conditions d'effacement.

24. Procédé selon la revendication 23, dans lequel les conditions de programme comportent au moins l'un des éléments parmi une tension de programmation d'impulsions par étapes incrémentales, une tension de début, une tension de commande de programme, un nombre maximum de boucles, un temps de programme monocycle ou une tension de vérification pour chaque état.

25. Procédé selon la revendication 23, dans lequel les conditions de lecture incluent au moins l'un des éléments parmi une tension de sélection de lecture, une tension de lecture de commande ou un temps de lecture monocycle.

26. Procédé selon la revendication 23, dans lequel les conditions d'effacement incluent au moins l'un des éléments parmi une tension d'effacement ou un temps d'effacement.

27. Procédé selon la revendication 18, dans lequel une plage d'au moins un paramètre de commande pour chaque groupe est différente d'une plage de l'au moins un paramètre de commande pour chaque autre groupe.

28. Procédé selon la revendication 18, dans lequel les cellules de mémoire sont des cellules de mémoire flash NON-ET.

29. Procédé selon la revendication 28, dans lequel les paramètres de commande incluent au moins une tension de programme en boucle appliquée à une page de mémoire flash NON-ET.

30. Procédé selon la revendication 28, dans lequel les paramètres de commande incluent au moins une tension de lecture en boucle appliquée à une page de mémoire flash NON-ET.

31. Procédé selon la revendication 28, dans lequel les paramètres de commande incluent au moins une tension d'effacement appliquée à un bloc de mémoire flash NON-ET.

32. Procédé selon la revendication 18, dans lequel les cellules de mémoire sont non volatiles.

33. Procédé selon la revendication 18, dans lequel chaque cellule de la pluralité de cellules de mémoire présente le même nombre de niveaux logiques.
